# EUROPEAN PATENT SPECIFICATION

(11) **EP 0 975 073 B1**
(45) Date of publication and mention of the grant of the patent: **04.12.2002**
(21) Application number: 99111787.0
(22) Date of filing: 18.06.1999
(51) Int. Cl.: H01S 5/32

(54) **Semiconductor laser**
Halbleiterlaser
Laser à semi-conducteur

(30) Priority: 19.06.1998 JP 17336898
(43) Date of publication of application: 26.01.2000
(73) Proprietor: NEC CORPORATION, Tokyo (JP)
(72) Inventor: Anan, Takayoshi, Minato-ku, Tokyo (JP)
(74) Representative: Glawe, Delfs, Moll & Partner

(56) References cited:
- WO-A-98/13879
- US-A- 4 599 728
- US-A- 5 737 353
- US-A- 5 767 535
- PATENT ABSTRACTS OF JAPAN vol. 018, no. 416 (E-1588), 4 August 1994 (1994-08-04) -& JP 06 125135 A (FUJITSU LTD), 6 May 1994 (1994-05-06)
- PATENT ABSTRACTS OF JAPAN vol. 097, no. 003, 31 March 1997 (1997-03-31) -& JP 08 316588 A (FURUKAWA ELECTRIC CO LTD:THE), 29 November 1996 (1996-11-29)
- ANTHONY P J ET AL: "DEVICE CHARACETERISTICS OF (AL,GA)AS LASERS WITH GA(AS,SB)ACTIVE LAYERS" IEEE JOURNAL OF QUANTUM ELECTRONICS, vol. QE-18, no. 7, 1 July 1982 (1982-07-01), pages 1094-1100, XP000705267

## Description

### BACKGROUND OF THE INVENTION

### 1. Field of the Invention

The present invention relates to a semiconductor laser, and more particularly it relates to a edge-emitting or surface-emitting semiconductor laser that emits in the 1.3-micron band and which can be used In an optical access system or in a optical Data-link system.

### 2. Description of the Related Art

An 1.3-micron band semiconductor laser is an important element for use as a light source in an optical access system. Successful lasers made chiefly from InGaAsP, InAlGaAs and InAsP on an InP substrate have been achieved for use in this wavelength band.

However, because the presence of a 1.3-micron band emitting material on a substrate of GaAs enables use of an almost self-aligning material such as AlGaAs or AlGaInP as an electron-confining layer on a GaAs substrate, it is possible to greatly reduce carrier leakage, which is a problem occurring with operation at high temperatures.

If a material that emits in the 1.3-micron band is used on a GaAs substrate, by using this in combination with a GaAs/AlAs semiconductor multilayer mirror, it is possible to achieve a surface-emitting laser in the long wavelength band of 1.3 microns.

A structure using GaInNAs has been reported on by Kondo et al with regard to long-wavelength emitting materials on a GaAs substrate. In Electronics Letters, Vol. 32, No. 24 (1996), pp 2244-2245, Kondo et al reported on a laser oscillation at 1.2 microns, using a quantum well structure of a GaInNAs quantum well layer and a GaAs barrier layer as the active layer on a on a GaAs substrate.

There has also been a report of a method of growing a large island-shaped (dot-shaped) non-aligned material on a GaAs substrate, so that, for example, an In_{0.5}Ga_{0.5}As crystal with a lattice misalignment of 3.5% is caused to grow, this being used as the active layer in a long-wavelength semiconductor laser.

This appeared as a laser using a quantum dot as an active layer, in Electronics Letters, Vol. 30, No. 17, pp. 1416-1417.

However, with the semiconductor laser reported on by Kondo et al, the quantum well light-emitting layer has a GaInNAs structure, making light emission at 1.3 microns or longer wavelengths dependent upon a further increase in the nitrogen component, thereby making it difficult to form a high-quality GaInNAs epitaxial growth layer.

In the case of using an InGaAs dot on a GaAs substrate, because of the small number of ground states of the quantum dots, in order to achieve the gain necessary for laser oscillation, as carriers are injected, carrier injection reaches a high level, resulting in a short-wavelength oscillation.

For this reason, the maximum wavelength for the case of an InGaAs dot is 1.1 µm.

It is therefore difficult to fabricate a 1.3 µm wavelength laser using a quantum dot on a GaAs substrate.

Accordingly, it is an object of the present invention to improve on the above-noted drawbacks of the prior, by providing a semiconductor laser that can be fabricated on a GaAs substrate, and that has an oscillation region in the 1.3-micron band.

### SUMMARY OF THE INVENTION

In order to achieve the above-noted objects, the present invention adopts the following basic technical constitution.

Specifically, one aspect of the present invention is a semiconductor laser which is provided with a quantum well layer made of GaAsSb in an active region, as defined in claim 1 and dependent claims 2-12.

A semiconductor laser according to the present invention makes use of the above-noted constitution, a feature of which is the provision of a quantum well layer made of GaAsSb in an active region, whereby it is possible to form a quantum well layer on a GaAs substrate and also possible to achieve a semiconductor that has a light-emitting region in the 1.3-micron band, because of the use of GaAsSb.

In the present invention, the GaAsSb that forms the above-noted quantum well layer has a composition that is represented as GaAs₁₋ₓSbₓ (where x is the mole proportion obtained by dividing the Sb mole amount by the total mole amount of As and Sb).

This GaAsSb composition, represented by GaAs₁₋ₓSbₓ, is a three-element mixed crystal that is based on the two two-element mixed crystals GaAs and GaSb, in which the group V elements As and Sb are mixed in a sub-lattice.

When group V elements mix in this manner in a sub-lattice, the bowing of the band gap increases, and the band gap becomes narrow.

As the amount of Sb content Sb, is increased, because the GaAsSb lattice constant becomes larger than the GaAs lattice constant, in order to cause epitaxial growth so that flaws caused by distortion of the GaAs substrate do not occur, it is necessary to make the thickness of the layer thinner, the greater is the Sb content x.

For this reason, using a GaAsSb crystal, there is an optimum range of Sb content x over which implementation is possible without reducing the light-emission intensity in the wavelength range from 1.2 µm to 1.3 µm.

Specifically, it is desirable that the Sb content amount x in the GaAsSb be 0.2 to 0.4 mole with respect to a total of 1 mole for As and Sb combined.

In this range, it is verified that it is possible to have a semiconductor laser according to the present invention emit light in the wavelength range from 1.2 to 1.35 µm.

From the newly gained knowledge of the inventors, in the optimum range of 0.2 to 0.4 mole of Sb content, the quantum well layer has a composition modulated structure in which there is alternation between two types of GaAsSb compositions having different Sb compositions, for example between GaAs_{0.6}Sb_{0.4} and GaAs_{0.8}Sb_{0.2}, in a direction that is different from the thickness direction, this typically being in a direction that is approximately perpendicular to the thickness direction.

By virtue of this composition modulated structure, there is further encouragement of the narrowing of the band gap, making it possible to achieve long-wavelength light emission with an even smaller amount of Sb.

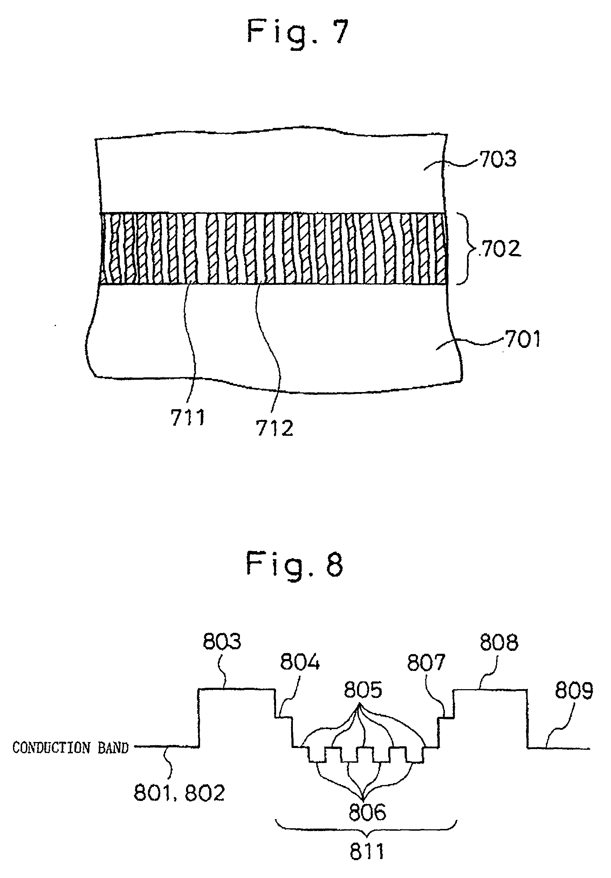

Fig. 7 shows as an example of the above-noted composition modulated structure, a trace of an electron microscope photograph of a quantum well layer 702 having a composition of GaAs_{0.7}Sb_{0.3}.

In this example, the quantum well layer 702, which is epitaxially joined to the (100) surface of the GaAs light waveguide layers 701 and 703, has a structure that alternates between a region 711 having a composition of GaAs_{0.6} Sb_{0.4} and a region 712 having a composition of GaAs_{0.8}Sb_{0.2}.

An example of a semiconductor laser according to the present invention will be described in further detail below, with reference being made to relevant drawings.

A semiconductor laser according to the present invention is suitable for use in virtually any type of edge-emitting or surface-emitting semiconductor laser, in which case it is possible to use a substrate made of GaAs.

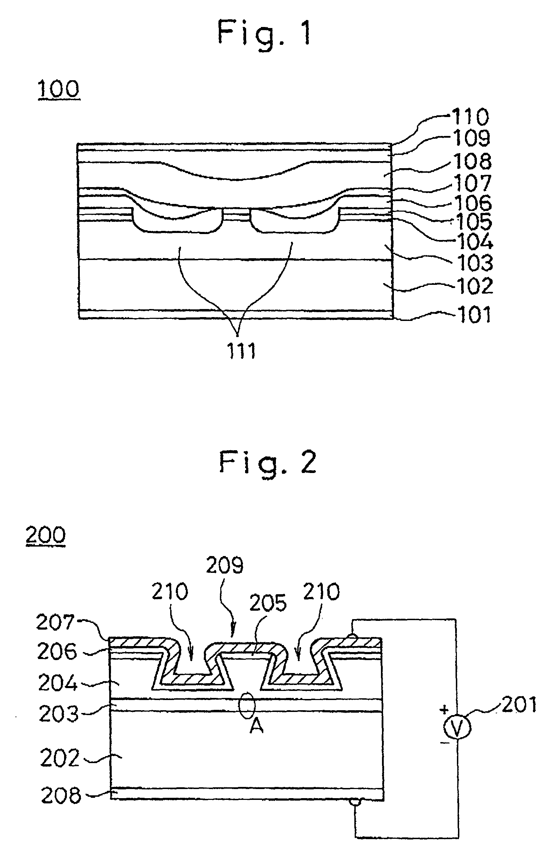

A typical edge-emitting or surface-emitting semiconductor laser is a so-called double hetero-junction semiconductor laser in which the action region that is formed between a first light waveguide layer and a second light waveguide layer having a different electrical conductivity, these each being formed on a substrate of GaAs or the like, and a typical edge-emitting semiconductor laser is a buried type of semiconductor laser, Fig. 1 showing as one example of a semiconductor laser of double-channel planar buried hetero-junction (DCPBH) structure.

That is, in the semiconductor laser that is shown in Fig. 1, an active layer 104 that forms an active region is provided on, for example, a GaAs substrate102, with an n-type GaAs buffer layer therebetween, a p-type GaAs clad layer 105, a p-type GaAs block layer 106, an n-type GaAs layer 107, a p-type GaAs buried layer 108, and a p-type GaAs cap layer 109 being laminated onto the active layer 104 in that sequence, a central stripe part of the active layer 104 being surrounded by downward hanging parts 111 of the GaAs blocking layer 106. In this drawing, the reference numerals 101 and 110 denote electrodes.

The semiconductor laser shown in Fig. 2 is called a ridge waveguide type semiconductor laser.

As shown in this drawing, an active layer 203 that serves as an active region and a p-type light waveguide layer 204 are laminated in this sequence onto an n-type light waveguide layer 202.

Additionally, a high-concentration p-type doped contact layer 205 is formed on the p-type light waveguide 204 and, to achieve current pinching, two trench structures 210 are provided, and an insulation film 206 is formed so that current does not flow except in a ridge 209 that is sandwiched between these trenches.

In this drawing, the reference numerals 207 and 208 denote a p-type and an n-type contact metal film, respectively, 201 is a voltage source, and when a voltage is applied across the metal films 207 and 208, current flows only in the ridge part 209, with light being emitted from the active layer 203.

The light that is emitted is guided in the ridge stripe direction by the upper and lower light waveguide layers.

The end of the stripe is an open wall surface, at which part of the light is reflected so that overall optical resonance is established. In this manner, laser oscillations occur at above a threshold current density.

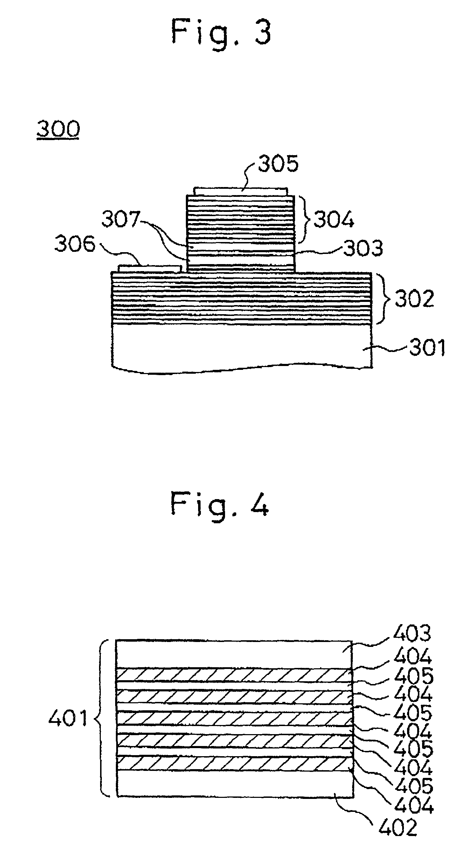

Fig. 3 shows a semiconductor laser of the surface-emitting type, in which for example on a GaAs substrate 301 are formed a multilayer structure n-type and p-type distributed Bragg reflector (DBR) formed by GaAs/AlAs films 302 and 304, between which is formed an active layer 303, with spacers 307 therebetween, which will serve as an active region.

In this drawing, the reference numerals 305 and 306 denote an anode and a cathode, respectively. In the examples shown in Fig. 1 through Fig. 3, the GaAs film or the like that is formed on a GaAs substrate can be formed as an epitaxially grown layer that is epitaxially joined to, for example, the GaAs (100) surface.

In the present invention, in the case in which a quantum well layer made of GaAsSb is provided in an active region, because it is sufficient to provide a quantum well structure part that includes a quantum well in part or all of the active region, the present invention encompasses the case in which there is also an active region that includes a quantum well structure that does not include, for example, a quantum well layer other than a quantum layer made of GaAsSb or a quantum well layer made of GaAsSb.

In this case, it is desirable that, in a quantum well structure that includes a quantum well made of GaAsSb, a barrier layer made of a material having a large band gap be provided on both sides of the quantum well layer.

For example, in the case in which a hetero-junction boundary is formed using GaAsSb and GaAs, the difference between the conduction band energies of GsAsSb and GaAs, that is, the value of discontinuity between the conduction bands is not that great, this being only approximately several tens meV, the result being that, in order to suppress carrier electron leakage at high temperatures, it is effective for GaAsSb to be sandwiched by materials having a band gap larger than that of GaAs, making it possible to achieve a conduction band discontinuity of, for example, 0.1 eV or greater.

Specifically, a substance suitable for use as a barrier layer can be selected from the group consisting of AlGaAs, GaAsP, AlGaAsP, GaInP, and AlGaInP. Of these materials, if the lattice constant is smaller than that of GaAs, there is the effect of suppressing compressive distortion of the GaAsSb, this resulting in structural stability, an advantage from the standpoint of laser reliability. More specifically, it is desirable that the material be selected from the group consisting of GaAsP, AlGaAsP, GaInP, and AlGaInP.

In these materials, by varying the composition of elements that are common to Group III or elements that are common to Group V, it is possible to achieve a lattice constant that is smaller than that of GaAs.

It should be noted, however, that in the case in which a quantum well layer made of GaAsSb is sandwiched between a barrier layer that has a band gap that is larger than that of GaAs, there is a great change in the quantum level, this causing a shift to a shorter wavelength, so that it could be difficult to achieve light emission in the 1.3-micron band.

This phenomenon becomes prominent when, because of distortion limitations, the thickness of the quantum well layer is restricted to 10 nanometers or less.

In this case, it is desirable from the standpoint of limiting the change in electron quantum level that an intermediate layer made of a substance having a band. edge energy that is intermediate between the band edge energy of the GaAsSb that forms the quantum well layer and the band edge energy of the barrier layer be provided between the quantum well layer and the barrier layer.

A material that is suitable for forming this intermediate layer can be selected from the group consisting of GaAs, GaAsP, and GaAsN.

Specifically, when the barrier layer is made of Al_{0.2}Ga_{0.8}As, an effective material to use as the intermediate layer is a GaAs layer of approximately 3 molecules.

Of the cited materials, a material that has a lattice constant that is smaller than that of GaAs is desirable, as this would result in an improvement in the stability with respect to distortion of the laminate structure and an increase in the effect of suppressing a change in electron level.

Specifically, the material can be selected from the group consisting of GaAsN and GaAsP. In these materials, by varying the composition of elements that are common to Group III or elements that are common to Group V, it is possible to achieve a lattice constant that is smaller than that of GaAs.

Fig. 4 through Fig. 6 show a specific example of an active layers 104 (enlarged part A in Fig. 2), 203, and 204, which are provided with a quantum well structure that includes the above-noted barrier layer and intermediate layer.

That is, in the active layer 401 shown in Fig. 4, a plurality of quantum well layers 405 that include Sb are provided between the upper and lower light waveguide layers 402 and 403, a barrier layer 404 being provided on each side of each quantum well layer 405.

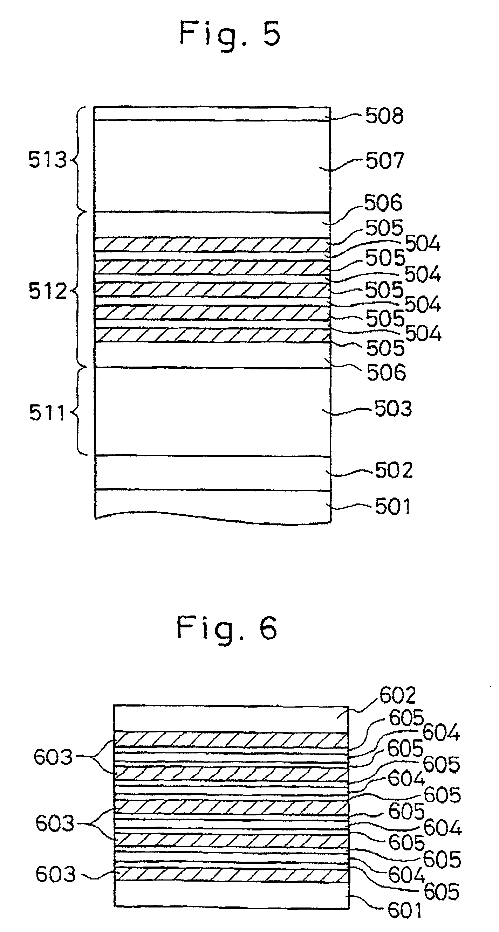

The example of Fig. 5, which is described in detail below, has the same structure as in Fig. 4.

Next, in the example that is shown in Fig. 6, there is an active layer structure that differs from that of the active layer 512 of Fig. 5, in which, between the lower and upper light waveguide layers 601 and 602, a plurality of quantum well layers 604 including Sb are provided, a barrier layer 603 being provided on each side of each of each quantum well layer 604, and also an intermediate layer 605 is provided between the quantum well layer 604 and barrier layer 603.

A typical thickness of this quantum well layer is 5 nm to 10 nm (50 to 100 Angstroms), there being from 1 to 5 and preferably from 2 to 3 such layers.

A typical thickness of the barrier layer is 10 nm to 30 nm (100 to 300 Angstroms), with the thickness of the intermediate layer being 3 to 5 molecules, this being, 0.9 nm to 1.5 nm (9 to 15 Angstroms).

### BRIEF DESCRIPTION OF THE DRAWINGS

Fig. 1 is a cross-section view of a DCPBH structure semiconductor laser, which is an embodiment of the present invention.

Fig. 2 is a cross-section view of a ridge structure semiconductor laser, which is an embodiment of the present invention.

Fig. 3 is a cross-section view of a surface-emitting semiconductor laser, which is an embodiment of the present invention.

Fig. 4 is a cross-section view that illustrates the configuration of an active region that is a feature of a semiconductor laser according to the present invention.

Fig. 5 is a cross-section view that specifically illustrates the characteristics of the active region of a semiconductor laser according to the present invention.

Fig. 6 is a cross-section view that illustrates the configuration of an active region that is a feature of a semiconductor laser according to the present invention.

Fig. 7 is a cross-section view that illustrates the composition modulated structure of a GaAsSb quantum well layer of the present invention.

Fig. 8 is a drawing of the band structure of a semiconductor laser manufactured as an embodiment of the present invention.

Fig. 9 is a drawing of the band structure of a semiconductor laser manufactured as an embodiment of the present invention.

Fig. 10 is a drawing of the band structure of a semiconductor laser manufactured as an embodiment of the present invention.

### DESCRIPTION OF THE PREFERRED EMBODIMENTS

Embodiments of a semiconductor laser according to the present invention are described in detail below, these embodiments achieving the above-noted object of the present invention, but not to be construed as placing any restriction on the present invention.

The first embodiment of the present invention is in the form of a so-called ridge waveguide semiconductor laser, the method of manufacture of which is shown in Fig. 2.

The epitaxial growth of layers onto a GaAs substrate is done using a gas source molecular beam epitaxy method.

As shown in Fig. 5, first a silicon doped (3 x 10¹⁸ cm⁻³) GaAs buffer layer 502 and then a silicon doped (1 x 10¹⁸ cm⁻³) Al_{0.4}Ga_{0.6}As layer 503, having a thickness of 1.5 µm are laminated onto a silicon doped (3 x 10¹⁸ cm⁻³) GaAs substrate, so as to form an n-type light waveguide 511.

Next, an undoped Al_{0.2}Ga_{0.8}As layer 506 is laminated to a thickness of 40 nanometers, after which period laminations are done of a 10-nanometer undoped GaAs barrier layer 505 and an 8-nanometer strained GaAs_{0.7}Sb_{0.3} quantum well layer 504, after which a 40-nanometer undoped Al_{0.2}Ga_{0.8}As layer 506 is laminated, thereby forming an active layer 512 that serves as an active region.

Additionally, onto this active layer 512, a 1.5 µm Be-doped (1 x 10¹⁸ cm⁻³) Al_{0.4}Ga_{0.8}As layer 507 is laminated so as to form a p-type light waveguide 513, and finally a 50-nanometer Be-doped (1 x 10¹⁹ cm⁻³) GaAs contact layer 508 is formed as a p-type contact layer.

In a ridge stripe laser such as shown in Fig. 2, lithography and chemical etching are first used to form trenches 210 on both sides of the ridge strip.

In the area other than the ridge strip upper surface, a 200-nanometer-thick SiO₂ insulation film 206 is formed, so that it is possible to insert current in only the ridge stripe part.

Then, a Ti/Au p-type metal contact layer 207 and a Ti/Au n-type metal contact layer 208 are formed and alloyed. The oscillation wavelength of this semiconductor laser at room temperature was 1.29 µm, and the threshold current density was 1.0 kA/cm².

The characteristic temperature from room temperature to 85°C was approximately 80K.

Fig. 8 shows the band structure of the first embodiment of the present invention obtained as described above.

In this drawing, the reference numerals 801, 802, 803, and 804 denote the bands of the GaAs substrate 501, the GaAs buffer layer 502, the Al_{0.4}Ga_{0.5} As layer 503, and the undoped Al_{0.2}Ga_{0.8}As layer 506, respectively, 805 and 806 are the bands of the undoped GaAs barrier layer 505 and the strained GaAs_{0.7} Sb_{0.3} quantum well layer 504, respectively, and 807, 808, and 809 are the bands of the undoped Al_{0.2}Ga_{0.8}As layer 506', the Al_{0.4}Ga_{0.6}As layer 507, and the p-type GaAs contact layer 508, respectively.

In this embodiment, a quantum well layer structure is formed by the alternating laminations of the GaAs barrier layer 505 and the distorted GaAsSb quantum well layer 504.

A feature of the present invention, as shown in Fig. 8, is the use of an Sb-based material as the light-emitting layer, and the achievement of light emission at a wavelength of 1.3µm or greater on a GaAs substrate.

Upon observation of the [ - 110] cross-section of the structure of this GaAsSb layer using a transmission electron microscope, a so-called composition modulation, in which the Sb composition changed with a period of approximately 1 nanometer in a direction perpendicular to the lamination direction, was observed.

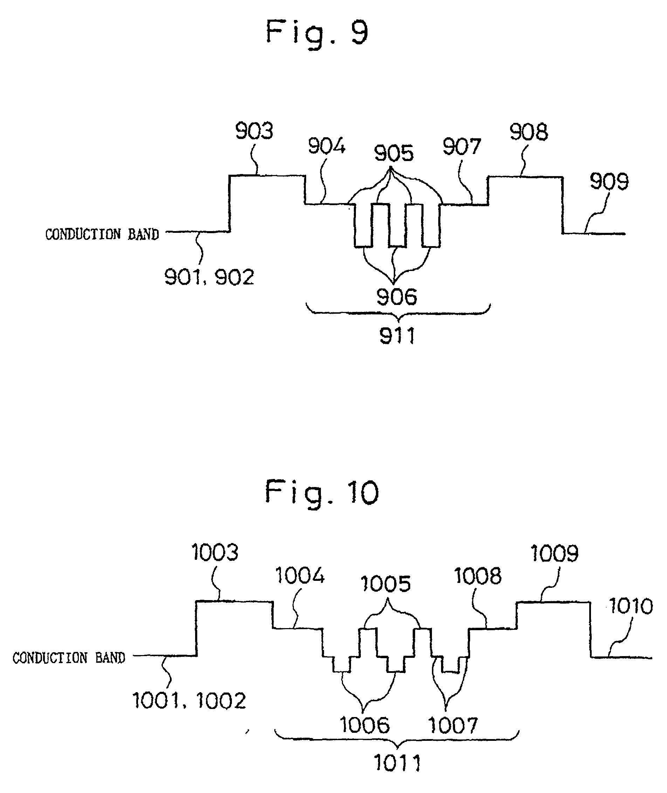

Fig. 9 shows the band structure of the second embodiment of the present invention, this being for the case in which a semiconductor laser provided with the same type of active region structure as in Fig. 5 is fabricated.

In this embodiment, periodic lamination is done of three layers, these being a 40-nanometer undoped Al_{0.2}Ga_{0.8}As layer 506, a 10-nanometer undoped AlGaAs barrier layer 505, and an 8-nanometer distorted GaAs_{0.7}Sb_{0.3} quantum well layer 504.

Over this periodic lamination is further laminated a 50-nanometer undoped Al_{0.2}Ga_{0.8}As layer 506' so as to form an active layer 512. In Fig. 9, the reference numerals 901, 902, 903, and 904 denote the bands of the GaAs substrate 501, the GaAs buffer layer 502, the Al_{0.4}Ga_{0.6}As layer 503, and the undoped Al_{0.2}Ga_{0.8} As layer 506, respectively, 905 and 906 are the bands of the undoped AlGaAs barrier layer 505 and the strained GaAs_{0.7}Sb_{0.8} quantum well layer 504, respectively, and 907, 908, and 909 are the bands of the undoped Al_{0.2}Ga_{0.8}As layer 506', the Al_{0.4}Ga_{0.6}As layer 507, and the p-type contact layer 508, respectively.

By using an Al_{0.2}Ga_{0.8}As layer as the barrier layer 505 of the quantum well layer structure, it is possible to make the discontinuity in the conduction band approximately 200 meV, thereby enabling achievement of sufficient electron confinement.

When a semiconductor laser having this type of active region was applied to a ridge waveguide type semiconductor laser such as in the first embodiment, it was found that the light emission wavelength at room temperature was 1.26 µm and the threshold current density was 1.1 kA/cm².

The characteristic temperature from room temperature to 85°C was approximately 100K.

The reason that the emission wavelength is shorter than the case of the first embodiment, in which AlGaAs is used in the barrier layer is that, by using AlGaAs in the barrier layer, there is a general shift in the electron quantum energy level to the high side.

Because AlGaAs is used to achieve a structure with sufficient electron confinement, there was an increase of the characteristic temperature from room temperature up to 85°C to 100K.

In this embodiment, although the description was for the case of using AlGaAs as the barrier layer, it should be noted that this can also be made of GaAsP, AlGaAsP, GaInP, or AlGaInP or the like.

In particular, if the material has a lattice constant that is smaller than GaAs, there is the effect of suppressing compressive strain of the GaAsSb, this resulting in structural stability, an advantage from the standpoint of laser reliability.

Fig. 10 shows the band structure for the case of the third embodiment of the present invention, this being a semiconductor laser which is provided with an active region having the same structure as shown in Fig. 6.

The active region 512 has a 40-nanometer undoped Al_{0.2}Ga_{0.8}As layer 601 and a 10-nanometer undoped AlGaAs layer 603, which serves as a barrier layer, and the quantum well layer 604 is an 8-nanometer strained GaAs_{0.7}Sb_{0.3} layer, on both sides of which are formed an intermediate layer 605, which has a conduction band energy that is intermediate between that of the barrier layer 603 and the quantum well layer 604.

In this embodiment, a 0.9-nanometer GaAs layer is used as the intermediate layer.

A periodic lamination of the above-noted three layers was done to form the quantum well layer in this manner, over which a 50-nanometer undoped Al_{0.2} Ga_{0.8}As layer 602 was laminated to form the active region 512.

In Fig. 10, the reference numerals 1001, 1002, 1003, and 1004 are the bands of the GaAs substrate 501, the GaAs buffer layer 502, the Al_{0.4}Ga_{0.6}As layer 503, and the undoped Al_{0.2}Ga_{0.8}As layer 601, respectively, 1005, 1006, and 1007 are the bands of the undoped AlGaAs barrier layer 603, the distorted GaAs_{0.7}Sb_{0.3} quantum well layer 604, and the intermediate layer 605, and 1008, 1009, and 1010 are the bands of the undoped Al_{0.2}Ga_{0.8}As layer 506', the Al_{0.} ₄Ga_{0.6}As layer 507, and the p-type GaAs contact layer 508, respectively.

By using an Al_{0.2}Ga_{0.8}As layer as the barrier layer 603 of the quantum well layer structure, it is possible to make the non-continuity in the conduction band approximately 200 meV, thereby enabling achievement of sufficient electron confinement.

Additionally, by providing a GaAs intermediate layer between the quantum well layer 604 and the barrier layer 603, it is possible to suppress a shift of electron quantum energy level to the high side and further possible to reduce the influence from the non-emitting junction centers in the AlGaAs layer.

When a semiconductor laser having this type of active region was applied to a ridge waveguide type semiconductor laser such as in the first embodiment, it was found that the light emission wavelength at room temperature was 1.28 µm and the threshold current density was 0.9 kA/cm².

The characteristic temperature from room temperature to 85°C was approximately 100K.

The reason that the emission wavelength is longer than the case of the second embodiment, in which AlGaAs is used in the barrier layer is that, by using GaAs as an intermediate layer, there is a suppression in the shift in the electron quantum energy level to the high side.

Also, by using a GaAs intermediate layer, the threshold current density is reduced in comparison with the case of the second embodiment, which uses AlGaAs.

In this embodiment, although the description was for the case of using GaAs as the barrier layer, it should be noted that this can also be made of GaAsP, GaAsN or the like, in which case, if the material such as GaAsN, which has a lattice constant that is smaller than GaAs is selected, there is the effect of suppressing compressive strain of the GaAsSb, this resulting in structural stability, an advantage from the standpoint of laser reliability.

In Fig. 8 through Fig. 10, the reference numerals 811, 911, and 1011 denote the range of each of the active layers.

While it is possible to fabricate the above-noted semiconductor lasers using the gas source molecular beam epitaxy method, fabrication is also possible using the metal organic vapor phase growth (MOVPE) method, and it is additionally possible to use as a light-confining structure of the active region a GRIN-SCH (graded index separate confinement heterostructure) which has a modified AlGaAs composition.

By adopting the technical constitution described in detail above, a semiconductor laser according to the present invention, provided with a quantum well layer made from GaAsSb in an active region, enables the formation of this quantum well layer on a GaAs substrate, and further enables the achievement of a semiconductor laser that emits light in the 1.3-micron band, using this GaAsSb.

## Claims

1. A semiconductor laser comprising a quantum well layer that is made from GaAsSb in an active region provided on a GaAs substrate (501), wherein a plurality of said GaAsSb layers (504) are adjacently arranged to each other,
***characterized in that***
the amount of Sb contained in said GaAsSb layers (504) is in the range from 0.2 to 0.4 moles with respect to a total 1 mole amount of As and Sb, and
wherein said quantum well layer exhibits composition modulation, in which the Sb content of said GaAsSb alternates in a direction that is nearly perpendicular to the thickness direction thereof.

2. A semiconductor laser according to claim 1, wherein said Sb content of at least one of said GaAsSb layers is different from that of the remaining said GaAsSb layers.

3. A semiconductor laser according to claim 1, wherein said active region is provided between a first light waveguide having a first conductivity and a second light waveguide layer having a second conductivity that is different from said first conductivity.

4. A semiconductor laser according to any of claim 1 through claim 3, comprising a quantum well structure part that includes said quantum well layer in at least part of said active region.

5. A semiconductor laser according to claim 4, comprising a barrier layer (505) that has a band gap that is larger than GaAs, said barrier layer being disposed on both sides of said quantum well layer.

6. A semiconductor laser according to claim 5, wherein the material used to form said barrier layer is selected from the group consisting of AlGaAs, GaAsP, AlGaAsP, GaInP and AlGaInP.

7. A semiconductor laser according to claim 5, wherein the lattice constant of said barrier layer is smaller than the lattice constant of GaAs.

8. A semiconductor laser according to claim 7, wherein the material used to form said barrier layer is selected from the group consisting of GaAsP, AlGaAsP, and AlGaInP.

9. A semiconductor laser according to claim 5, further comprising, between said quantum well layer (504) and said barrier layer (505), an intermediate layer (605) that is made of a material that has a band edge energy that is intermediate between the band edge energy of said quantum well layer and the band edge energy of said barrier layer that forms said quantum well layer.

10. A semiconductor laser according to claim 9, wherein the material that forms said intermediate layer is selected from the group that consists of GaAs, GaAsP, and GaAsN.

11. A semiconductor laser according to claim 9, wherein the lattice constant of the material that forms said intermediate layer is smaller than the lattice constant of GaAs.

12. A semiconductor laser according to claim 11, wherein the material that forms said intermediate layer is selected from the group that consists of GaAsN and GaAsP.

## Patentansprüche

1. Halbleiterlaser mit einer Quantenwellschicht, die aus GaAsSb in einer aktiven Region gemacht ist, die in einem GaAs-Substrat (501) vorgesehen ist, wobei eine Vielzahl von GaAsSb-Schichten (504) nebeneinander angeordnet sind,
**dadurch gekennzeichnet, daß**
die Menge von Sb, die in den GaAsSb-Schichten (504) enthalten ist, im Bereich von 0,2 bis 0,4 Mol liegt bezüglich einer Gesamtmenge von As und Sb von einem Mol,
wobei die Quantenwellschicht eine Zusammensetzungsmodulation aufweist, bei welcher der Sb-Gehalt von GaAsSb in einer Richtung nahezu senkrecht zur Dickenrichtung alterniert.

2. Halbleiterlaser nach Anspruch 1,
wobei der Sb-Gehalt mindestens einer der GaAsSb-Schichten unterschiedlich von dem der verbleibenden GaAsSb-Schichten ist.

3. Halbleiterlaser nach Anspruch 1,
wobei der aktive Bereich vorgesehen ist zwischen einem ersten Lichtwellenleiter mit einer ersten Leitfähigkeit und einem zweiten Lichtwellenleiter mit einer von der ersten Leitfähigkeit unterschiedlichen Leitfähigkeit.

4. Halbleiterlaser nach einem der Ansprüche 1 bis 3,
mit einem Quantenwell-Strukturteil, der die Quantenwell-Schicht in mindestens einem Teil des aktiven Bereichs enthält.

5. Halbleiterlaser nach Anspruch 4,
mit einer Barriereschicht (505), die eine Bandlücke hat, die größer als GaAs ist, wobei die Barriereschicht auf beiden Seiten der Quantenwellschicht angeordnet ist.

6. Halbleiterlaser nach Anspruch 5,
wobei das Material, das zur Formung der Barriereschicht verwendet wird, gewählt ist aus der Gruppe bestehend aus AlGaAs, GaAsP, AlGaAsP, GaInP und AlGaInP.

7. Halbleiterlaser nach Anspruch 5,
wobei die Gitterkonstante der Barriereschicht kleiner ist als die Gitterkonstante von GaAs.

8. Halbleiterlaser nach Anspruch 7,
wobei das Material, das zur Ausformung der Barriereschicht benutzt wird, gewählt ist aus der Gruppe bestehend aus GaAsP, AlGaAsP und AlGaInP.

9. Halbleiterlaser nach Anspruch 5,
welche ferner zwischen der Quantenwellschicht (504) und der Barriereschicht (505) eine Zwischenschicht (605) aufweist, die aus einem Material gemacht ist, das eine Bandkantenenergie aufweist, die zwischen der Bandkantenenergie der Quantenwellschicht und der Bandkantenenergie der Barriereschicht ist, die die Quantenwellschicht bildet.

10. Halbleiterlaser nach Anspruch 9,
wobei das Material, das die Zwischenschicht bildet, gewählt ist aus der Gruppe bestehend aus GaAs, GaAsP und GaAsN.

11. Halbleiterlaser nach Anspruch 9,
wobei die Gitterkonstante des Materials, das die Zwischenschicht bildet, geringer ist als die Gitterkonstante von GaAs.

12. Halbleiterlaser nach Anspruch 11,
wobei das Material, das die Zwischenschicht ausbildet, gewählt ist aus der Gruppe bestehend aus GaAsN und GaAsP.

## Revendications

1. Laser à semi-conducteur comprenant une couche de puits quantique faite à partir de GaAsSb dans une région active prévue sur un substrat de GaAs (501), dans lequel une pluralité desdites couches de GaAsSb (504) sont disposées de façon adjacente les unes aux autres,
**caractérisé en ce que**
la quantité de Sb contenue dans lesdites couches de GaAsSb (504) se situe dans l'intervalle de 0,2 à 0,4 mole relativement à une quantité totale de As et de Sb de 1 mole, et
dans lequel ladite couche de puits quantique présente une modulation de composition, dans laquelle la teneur en Sb dudit GaAsSb alterne dans une direction qui est quasiment perpendiculaire à la direction de son épaisseur.

2. Laser à semi-conducteur selon la revendication 1, dans lequel ladite teneur en Sb d'au moins une desdites couches de GaAsSb est différente de celle desdites couches restantes de GaAsSb.

3. Laser à semi-conducteur selon la revendication 1, dans lequel ladite région active est prévue entre un premier guide d'onde de lumière ayant une première conductivité et une seconde couche de guide d'onde de lumière ayant une seconde conductivité qui est différente de ladite première conductivité.

4. Laser à semi-conducteur selon l'une quelconque des revendications 1 à 3, comprenant une partie à structure de puits quantique qui comprend ladite couche de puits quantique dans au moins une partie de ladite région active.

5. Laser à semi-conducteur selon la revendication 4, comprenant une couche de barrière (505) qui a une largeur de bande interdite plus importante que GaAs, ladite couche de barrière étant disposée des deux côtés de ladite couche de puits quantique.

6. Laser à semi-conducteur selon la revendication 5, dans lequel le matériau utilisé pour former ladite couche de barrière est sélectionné à partir du groupe consistant en AlGaAs, GaAsP, AlGaAsP, GaInP et AlGaInP.

7. Laser à semi-conducteur selon la revendication 5, dans lequel la constante de réseau de ladite couche de barrière est plus petite que la constante de réseau de GaAs.

8. Laser à semi-conducteur selon la revendication 7, dans lequel le matériau utilisé pour former ladite couche de barrière est sélectionné à partir du groupe consistant en GaAsP, AlGaAsP et AlGaInP.

9. Laser à semi-conducteur selon la revendication 5, comprenant en outre, entre ladite couche de puits quantique (504) et ladite couche de barrière (505), une couche intermédiaire (605) qui est faite d'un matériau qui a une énergie d'extrémité de bande qui est intermédiaire entre l'énergie d'extrémité de bande de ladite couche de puits quantique et l'énergie d'extrémité de bande de ladite couche de barrière qui forme ladite couche de puits quantique.

10. Laser à semi-conducteur selon la revendication 9, dans lequel le matériau qui forme ladite couche intermédiaire est sélectionné à partir du groupe consistant en GaAs, GaAsP et GaAsN.

11. Laser à semi-conducteur selon la revendication 9, dans lequel la constante de réseau du matériau qui forme ladite couche intermédiaire est plus petite que la constante de réseau de GaAs.

12. Laser à semi-conducteur selon la revendication 11, dans lequel le matériau qui forme ladite couche intermédiaire est sélectionné à partir du groupe consistant en GaAsN et GaAsP.
